# EUROPÄISCHE PATENTSCHRIFT

(11) **EP 1 062 679 B1**
(45) Veröffentlichungstag und Bekanntmachung des Hinweises auf die Patenterteilung: **21.11.2001**
(21) Anmeldenummer: 99966898.1
(22) Anmeldetag: 31.12.1999
(51) Int. Cl.: H01J 37/32

(54) **PLASMAÄTZANLAGE**
PLASMA ETCHING INSTALLATION
INSTALLATION DE GRAVURE AU PLASMA

(30) Priorität: 07.01.1999 DE 19900179
(43) Veröffentlichungstag der Anmeldung: 27.12.2000
(73) Patentinhaber: ROBERT BOSCH GMBH, 70442 Stuttgart (DE)
(72) Erfinder: BECKER, Volker, D-76359 Marxzell (DE); LAERMER, Franz, D-70437 Stuttgart (DE); SCHILP, Andrea, D-73525 Schäbisch Gmünd (DE); BECK, Thomas, D-71737 Kirchber/Murr (DE)
(86) Internationale Anmeldenummer: DE9904130
(87) Internationale Veröffentlichungsnummer: WO0041210

(56) Entgegenhaltungen:
- WO-A-99/01887
- US-A- 5 332 880
- US-A- 5 573 595
- US-A- 5 637 961

## Beschreibung

### Stand der Technik

Die Erfindung betrifft eine Plasmabearbeitungsanlage nach der Gattung des Hauptanspruches.

Derartige Plasmabearbeitungsanlagen, die induktive gekoppelte Plasmaquellen verwenden, sind insbesondere zum Siliziumtiefenätzen mit sehr hohen Ätzraten unter Einsatz des in DE 42 41 045 offenbarten Verfahrens geeignet und vielfach bekannt. Eine einfache und bewährte Anordnung besteht aus einer ICP-Spule (ICP = "inductively coupled plasma"), die um ein Plasmavolumen herumgewickelt ist und mit einer hochfrequenten Wechselspannung gespeist wird. Die durch die ICP-Spule fließenden hochfrequenten Ströme induzieren in das Plasmavolumen ein hochfrequentes magnetisches Wechselfeld, dessen elektrisches Wirbelfeld nach dem Induktionsgesetz (rotE = - ∂B/∂t) wiederum die Plasmaerregung durchführt. Die eingesetzte Hochfrequenz weist Werte zwischen 600 kHz und 27 MHz auf, üblicherweise findet eine Frequenz von 13,56 MHz Verwendung.

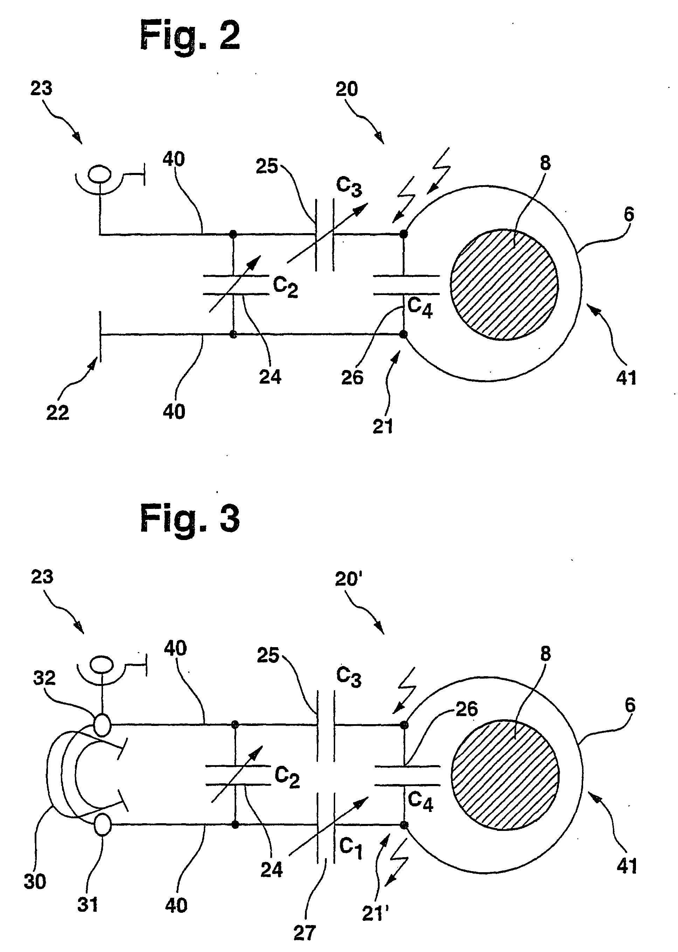

In dem aus DE 42 41 045 bekannten Verfahren wird eine Plasmaquelle mit vorzugsweiser induktiver Hochfrequenzanregung benutzt, um aus einem fluorliefernden Ätzgas Fluorradikale und aus einem teflonbildende Monomere liefernden Passiviergas (CF₂)ₓ - Radikale freizusetzen, wobei die Plasmaquelle ein hochdichtes Plasma mit einer relativ hohen Dichte von Ionen (10¹⁰-10¹² cm⁻³) niedriger Energie generiert und die Ätz- und Passiviergase alternierend eingesetzt werden. Die Ionenenergie, mit der die erzeugten Ionen zur Substratoberfläche beschleunigt werden, ist ebenfalls relativ niedrig und liegt zwischen 1 - 50 eV, vorzugsweise 5 - 30 eV. Die Figur 2 der Beschreibung zeigt eine aus dem Stand der Technik bekannte, üblicherweise verwendete unsymmetrische Speisung der ICP-Spule einer solchen Plasmaquelle, die im einfachsten Fall aus nur einer einzigen Windung um einen Reaktor in Form eines Kessels aus keramischem Material mit einem Durchmesser von beispielsweise 40 cm Durchmesser besteht. Ein Spulenende ist geerdet, das andere Spulenende wird mit der hochfrequenten Wechselspannung gespeist und als "heiß" bezeichnet, weil sich an diesem Spulenende sehr hohe Spannungen von z.B. 1000 - 3000 Volt aufbauen, die typisch sind für die Amplitude der eingespeisten hochfrequenten Hochspannung.

Die in Figur 2 ebenfalls dargestellten Kapazitäten C₂ und C₃ dienen zur Anpassung der Impedanz eines asymmetrischen 50 Ω-Koaxialkabelausgangs einer verwendeten Hochfrequenzeinspeisung an die Impedanz der asymmetrisch betriebenen ICP-Spule (sogenannte "Matchbox" oder "Matching-Kapazitäten"). Der Kondensator C₄ ist parallel zur ICP-Spule geschaltet und stellt zusammen mit den Matching-Kapazitäten die Resonanzbedingung her.

Die bekannte asymmetrische und induktive Speisung der Plasmaquelle hat zur Folge, daß sich die Asymmetrie auch in das erzeugte Plasma hinein abbildet, welches im Mittel, je nach Stärke einer auftretenden kapazitiven Kopplung, einige Volt bis einige 10 Volt oberhalb des Erdpotentials liegt. Ein Spulenende der ICP-Spule liegt somit auf Erdpotential (0 V) und das gegenüberliegende "heiße" Spulenende liegt auf hoher hochfrequenter Spannung von bis zu einigen tausend Volt. Dadurch werden insbesondere am "heißen" Spulenende starke elektrische Felder durch die keramische Kesselwand des Reaktors in das Plasma induziert, was wiederum Verschiebeströme durch die keramische Kesselwand in das Plasma zur Folge hat. Man spricht hierbei von der bereits erwähnten "kapazitiven Kopplung", während die eigentliche Plasmaerzeugung ein induktiver, d.h. auf zeitvariablen magnetischen Feldern basierender Mechanismus ist.

Im wesentlichen erfolgt vom gespeisten, d.h. "heißen" Spulenende durch die kapazitive Kopplung ein Stromfluß durch die keramische Kesselwand des Reaktors in das Plasma. Dieser Stromfluß kann, da sich das mittlere Plasmapotential in der Nähe des Erdpotentials bewegt, auf das auch das "kalte" Spulenende festgelegt ist und die Spannungsdifferenz zwischen Plasma und "kaltem" Spulenende zu gering ist, um den Verschiebestrom über die keramische Kesselwand wieder zur Spule hin abfließen zu lassen, nicht zum geerdeten Spulenende abfließen. Somit muß der Verschiebestrom aus dem Bereich des "heißen" Spulenendes in das Plasma hinein über eine Erde wieder aus dem Plasma heraus abfließen, welche im direkten Kontakt mit dem Plasma steht. Dies ist im Stand der Technik bisher im wesentlichen die Substratelektrode, die beispielsweise als Substrat einen Wafer trägt und die über eine eigene Hochfrequenzspeisung auf einem niedrigen negativen DC-Biaspotential von 1 - 50 V gegenüber dem Plasma betrieben wird. Sie kann daher die erwähnten Verschiebeströme direkt aufnehmen, was jedoch zu Inhomogenitäten des jeweiligen Plasmabearbeitungsverfahrens über die Substratoberfläche und damit teilweise zu erheblichen Profilabweichungen beim Ätzen in einzelnen Bereichen führt.

Desweiteren verzerren die über die asymmetrische Einspeisung einseitig auftretenden starken elektrischen Felder die Lage und Dichteverteilung des erzeugten Plasmas, das aus der Mitte des Reaktors heraus verschoben wird und sich beispielsweise in Richtung auf das "heiße" Spulenende verlagert. Man spricht hier von einem sogenannten "Bull's eye shift", weil sich die Inhomogenität des Plasmas augenförmig auf den als Substrat verwendeten Wafern abbildet und sich dieses "Auge" aus der Wafermitte heraus zum Waferrand verschiebt.

Eine erste Maßnahme zur Verbesserung der Prozeßhomogenität und zur Vermeidung des "Bull's eye shift" ist für einen aus der DE 42 41 045 bekannten Prozeß in der unveröffentlichten Anmeldung DE 197 34 278.7 beschrieben, in der eine Aperturkonstruktion vorgeschlagen wird, die über eine ausgedehnte Ionenrekombinationszone auf der Innenwand eines auf einer Apertur montierten Metallzylinders den Ionenfluß zum Substrat über die jeweilige Substratoberfläche homogenisiert, indem im Außenbereich des zum Substrat gelangenden Plasmas ein Ionenverlustmechanismus eingebaut wird, sowie das Plasma rezentriert und elektrische Felder aus dem Quellenbereich des Plasmas auf dem Weg zum Substrat teilweise abgeschirmt werden.

Eine weitere Maßnahme, welche Profilabweichungen geätzter Strukturen auf dem Substrat oder einem Wafer reduziert, die teilweise infolge elektrischer Störfelder auftreten, wird in der unveröffentlichten Anmeldung DE 197 363 70.9 vorgeschlagen, in der ein sogenanntes "Parameter-Ramping" eingesetzt wird.

Ebenso wie das "heiße" Spulenende ist auch das "kalte" Spulenende, d.h. das im Stand der Technik geerdete Spulenende eine Problemzone, weil dieses Ende der Ort der minimalen Verschiebestromeinkopplung bzw. -auskopplung durch die kapazitive Kopplung in das erzeugte Plasma ist. Darüberhinaus ist bisher die Erdung des zugehörigen "kalten" Speisespannungspunktes der ICP-Spule, der mit dem "kalten" Spulenende in Verbindung steht, mit größter Sorgfalt vorzunehmen, da insbesondere vertikal fließende Ströme, d.h. Ströme von der ICP-Spule nach unten zum geerdeten Gehäuse, in einer wirksamen Umgebung des Plasmareaktors unbedingt vermieden werden müssen. Solche vertikalen, das heißt nicht parallel zur der von der ICP-Spule definierten Spulenebene fließenden Ströme haben ein um 90° verkipptes zeitvariables Magnetfeld mit entsprechenden elektrischen Induktionswirkungen über das elektrische Wirbelfeld zur Folge, was zu beträchtlichen lokalen Störungen des Plasmas führt, die sich wiederum in Profilabweichungen (Taschenbildung, negative Ätzflanken, Maskenrandhinterschneidung) wiederfinden.

Ein weiterer, bei Verfahren aus dem Stand der Technik bekannter Störeffekt durch hohe Spannungen an einem "heißen" Spulenende besteht darin, daß dort die Reaktorseitenwand innenseitig durch Ionenbeschuß, d.h. von durch starke elektrische Felder zur Kammerwand beschleunigten positiv geladenen Ionen, abgesputtert wird. Dabei kann auch abgesputtertes Wandmaterial auf den Wafer bzw. das Substrat gelangen und dort als Mikromaskierung wirken, was bekanntermaßen die Bildung von Siliziumnadeln, Mikrorauhigkeiten oder Siliziumpartikeln zur Folge hat. Da der Sputterabtrag der Reaktorseitenwand mit einer Potenzfunktion der anliegenden hochfrequenten Spannung skaliert, ist es im Sinne minimaler Sputterraten wünschenswert, wenn die an der ICP-Spule anliegende hochfrequente Spannung zum Plasma hin möglichst klein gehalten wird.

Ein aus dem Stand der Technik bereits bekannter Lösungsvorschlag zur symmetrischen Speisung der ICP-Spule sieht vor, einen Transformator zu verwenden, dem primärseitig eine hochfrequente Wechselspannung über eine Hochfrequenzeinspeisung zugeführt wird, und der eine Sekundärspule mit geerdeter Mittenanzapfung aufweist, so daß der Transformator den beiden Enden der ICP-Spule einer Plasmabearbeitungsanlage eine hochfrequente, gegenphasige Hochspannung zumindest nahezu gleicher Amplitude zuführen kann. Ein solcher Transformator wird üblicherweise mittels einer Spulenwicklung aus Litzendraht auf einem Ferritkernmaterial ausgeführt, wobei als Ferritkern ein Topfkern oder Ringkern verwendet wird. Derartige Transformatoren haben jedoch den gravierenden Nachteil, daß hohe Magnetisierungsverluste der Kernmaterialien bei Frequenzen von beispielsweise 13,56 MHz auftreten, die im Bereich von 10-20 % betragen. Dies führt bei den hohen eingesetzten Hochfrequenzleistungen, die bei ICP-Plasmabearbeitungsanlagen üblicherweise zwischen 500 Watt bis 3000 Watt liegen, zu erheblichen thermischen Problemen. Darüberhinaus treten infolge der frequenzabhängigen Energieabsorption durch das Kernmaterial in dem Transformator auch Phasenfehler auf, die die zur gegenphasigen Einkopplung benötigte 180°-Phase der beiden eïnzukoppelnden Hochspannungen am symmetrischen Ausgang teilweise erheblich verfälschen. Überdies begrenzen derartige Transformatoren die einsetzbare Hochfrequenzleistung, die in das Plasma eingekoppelt wird in unerwünschter Weise.

Aus der nachveröffentlichten Anmeldung WO 99/01887 ist eine Plasmabearbeitungsanlage bekannt, bei der das Plasma im Wesentlichen induktiv angeregt wird, um eine gleichmäßige Anregung zu erreichen. Die dabei an die Spule angelegten Wechselspannungen werden mit Hilfe eines Transformators erzeugt, so dass die an den beiden Spulenenden anliegenden Wechselspannungen gegenphasig zueinander sind, und sich am Ort der Spulenmitte eine virtuelle Erdung ausbildet.

### Vorteile der Erfindung

Die erfindungsgemäße Plasmabearbeitungsanlage mit den kennzeichnenden Merkmalen des Hauptanspruches hat gegenüber dem Stand der Technik den Vorteil, daß beide Spulenenden über eine symmetrische Spulenspeisung mit einer hochfrequenten Spannung gleicher Frequenz gespeist werden, wobei die symmetrische Speisung der ICP-Spule mit zwei hochfrequenten, zueinander gegenphasigen Wechselspannungen an einem ersten Spulenende und einem zweiten Spulenende mittels einer λ/2-Verzögerungsleitung (einem sogenannten "Kabel-BALUN") erfolgt, die zwischen einem ersten Speisespannungspunkt und einem zweiten Speisespannungspunkt vorgesehen ist und diese verbindet. Die λ/2-Verzögerungsleitung bewirkt spannungs- und leistungsunabhängig eine Phasenverschiebung von 180° der an einem ersten Speisespannungspunkt eingekoppelten Spannung U(t) und somit eine Einkoppelung von -U(t) an einem zweiten Speisespannungspunkt. Somit werden ohne größeren technischen Aufwand und ohne zusätzliche kostenintensive Bauteile aus einer von der Hochfrequenzeinspeisung bereitgestellten Spannung zwei hochfrequente gegenphasige Wechselspannungen mit gleicher Frequenz und zumindest nahezu gleicher Amplitude generiert. Insbesondere sind damit für induktive Plasmaquellen besonders einfache, verlustarme und für hohe Hochfrequenzleistungen (mehrere Kilowatt) taugliche Plasmabearbeitungs- bzw. Plasmaätzverfahren möglich.

Weiterhin werden bei der erfindungsgemäßen symmetrischen Speisung der ICP-Spule jetzt beide Spulenenden "heiß", das heißt die beiden Spulenenden führen nun eine hochfrequente Wechselspannung von beträchtlicher, im Idealfall identischer Amplitude, welche an den beiden Spulenenden exakt gegenphasig auftritt. Liegt also an dem ersten Spulenende eine Spannung Û(t) an, so liegt an dem zweiten Spulenende entsprechend eine Spannung -Û(t) an, deren Amplitude gegenüber der asymmetrischen Speisung aus dem Stand der Technik nur noch halb so groß ist, weil die ursprüngliche Wechselspannung 2*Û(t) gegen Erde nunmehr in Û(t) und -Û(t) gegen Erde aufgeteilt ist. Durch diese Halbierung der Spannungsamplitude an den beiden Spulenenden nehmen sehr vorteilhaft zunächst störende Wandsputterraten an der Reaktorinnenwand drastisch ab.

Daneben nimmt sehr vorteilhaft auch der Anteil unerwünschter, hochenergetischer Ionen ab, die ansonsten durch hohe elektrische Felder zur Reaktorwand beschleunigt und dort reflektiert werden und somit wieder in das erzeugte Plasma zurückkehren und dort Ursache für zahlreiche Störeffekte auf dem prozessierten Substrat wie beispielsweise Profilstörungen oder Schäden an Oxidschichten auf einem geätzten Wafer sind. Gleichzeitig nimmt vorteilhaft auch der Anteil hochenergetischer Elektronen im erzeugten Plasma ab, da die kapazitive Stromeinkopplung in das erzeugte Plasma durch die symmetrische Spulenspeisung erheblich (mindestens um einen Faktor 2) reduziert ist und damit das Elektronengas nicht mehr in relevanter Weise aufgeheizt wird. Das erzeugte Plasma wird somit sehr vorteilhaft kälter. Hochenergetische Elektronen sind für die Plasmaprozesse überdies generell unerwünscht, weil sie unnötig Hochfrequenzleistung absorbieren.

Da die elektrischen Streufelder aus dem Spulenbereich bei symmetrischer Spulenspeisung gegensinnig gleich sind, egalisieren sie sich überdies sehr vorteilhaft, so daß der sogenannte "Bull's eye shift" nicht mehr auftritt.

Ferner sind die in das erzeugte Plasma kapazitiv eingekoppelten Ströme, die, wie erwähnt, bereits deutlich kleiner sind, nunmehr ebenfalls gegensinnig gleich, d.h. sie egalisieren sich zwischen den Spulenenden und fließen sehr vorteilhaft nicht mehr über mit dem Plasma in unmittelbaren Kontakt stehende Erdungen wie beispielsweise die Substratelektrode und das bearbeitete Substrat ab.

Da bei der erfindungsgemäßen Plasmabearbeitungsanlage an jedem der beiden Spulenenden der ICP-Spule zu jedem Zeitpunkt der negative Spannungswert des jeweils anderen Spulenendes anliegt, kann der von einem Spulenende über die keramische Reaktorwand als Dielektrikum in das erzeugte Plasma induzierte Verschiebestrom von dem anderen Spulenende ebenfalls über die keramische Reaktorwand als Dielektrikum aufgenommen werden, so daß kein Ladungsausgleich über ein Erdpotential, d.h. beispielsweise über die Substratoberfläche, erfolgen muß. Damit verbessert sich die Ätzraten- und Profilhomogenität über die Substratoberfläche erheblich und es treten weniger Profilabweichungen auf.

Weiterhin rückt das Plasmapotential vorteilhaft näher an das Erdpotential heran, da elektrische Einkopplungen in das Plasma deutlich abnehmen und die verbliebenen Einkopplungen aufgrund ihrer Symmetrie egalisiert werden. Überdies nimmt auch die Plasmasymmetrie vorteilhaft zu, da man durch die Abnahme der das Plasma verzerrenden kapazitiven Einkopplung bzw. deren Egalisierung ein kälteres und im Idealfall rotationssymmetrisches Plasma ohne auffällige Potentialunterschiede an einzelnen Punkten im Plasma erhält.

Vorteilhafte Weiterbildungen der Erfindung ergeben sich aus den in den Unteransprüchen genannten Maßnahmen.

So ist es weiterhin auch bei symmetrischer Speisung der ICP-Spule vorteilhaft, alle stromführenden Leiter in einer wirksamen Umgebung des Reaktors oder der ICP-Spule parallel zu der von der ICP-Spule definierten Spulenebene zu führen. Unter Umgebung ist dabei ein Bereich um den Reaktor und die ICP-Spule zu verstehen, in dem über elektromagnetische Wechselwirkungen zwischen den in den Leitern fließenden Strömen und dem erzeugten Plasma relevante störende Einflüsse auftreten. Somit fließen vorteilhaft nur parallel geführte konzentrierte Ströme in der Nähe des erzeugten Plasmas, welche keine schädlichen magnetischen Störfelder in das Plasma induzieren, das somit weniger Störungen aufweist und kälter ist, so daß auch eine mögliche Substratschädigung durch hochenergetische Ionen oder Elektronen erheblich abnimmt. Gleichzeitig reduziert sich somit auch das Plasmapotential und nähert sich dem Erdpotential an.

Durch Kombination der λ/2-verzögerungsleitung mit einem zwischen den beiden Speisespannungspunkten und den beiden Spulenenden installierten, vorzugsweise symmetrischen, kapazitiven Netzwerk zur Impedanzanpassung an das erzeugte induktive Plasma kann sehr vorteilhaft nahezu verlustfrei eine symmetrische Speisung der ICP-Spule erreicht werden. In Kombination mit einer Reduzierung der Speisespannungsamplituden an den beiden Spulenenden erlaubt die erfindungsgemäße symmetrische Speisung der ICP-Spule somit sehr hohe Einspeiseleistungen in das erzeugte Plasma als induktive Plasmaquelle, die bis in den Bereich mehrerer Kilowatt reichen, sowie ein Hochskalieren der Leistungsparameter der Plasmabearbeitungsanlage, was letztlich zu höheren Ätzraten führt.

Da bei der erfindungsgemäßen symmetrischen Spulenspeisung beide Spulenenden "heiß" sind, wenn auch auf niedrigerem Niveau, ist es weiterhin sehr vorteilhaft, die beiden "heißen" Spulenenden in einem vergrößerten Abstand zu dem keramischen Kessel, der das erzeugte hochdichte Plasma in Form eines Reaktors umschließt, anzuordnen. Am einfachsten wird dies erreicht, indem die das Plasma erzeugende ICP-Spule, die den Reaktorkessel außerhalb bereichsweise zumindest weitgehend umgibt, einen etwas größeren Durchmesser hat als der Reaktoraußendurchmesser und so um den Reaktor plaziert wird, daß die den beiden Spulenenden gegenüberliegende Seite der ICP-Spule die Keramik des Reaktorkessels gerade berührt. Der Reaktorkesselkreis tangiert damit den größeren, ihn umschließenden Spulenkreis an der entgegengesetzt zu den Spulenenden liegenden Spulenseite. Auf diese Weise nimmt vorteilhaft der Abstand der ICP-Spule zu dem im Inneren des Reaktors erzeugten Plasma mit anwachsendem elektrischen Potential zu, wobei die beiden Spulenenden als die Orte des höchsten elektrischen Potentials den maximalen Abstand zu dem Reaktor aufweisen. Dazu genügen bereits ca. 1 - 2 cm. Auch in diesem Fall ist es von großer Bedeutung, daß alle stromführenden Leiter in der Umgebung des Reaktors horizontal in der von der ICP-Spule definierten Spulenebene verlaufen, um störende hochfrequente Magnetfelder vom Plasma fernzuhalten.

Weiterhin ist es nunmehr in sehr vorteilhafter Weise möglich, die beschriebene symmetrische Spulenspeisung mit der in der unveröffentlichten Anmeldung DE 197 34 278.7 vorgeschlagenen Aperturkonstruktion zu kombinieren, die das hochfrequente Magnetfeld der ICP-Spule am Ort des Substrates weiter reduziert und die Plasadichteverteilung homogenisiert.

Es ist zudem in der erfindungsgemäßen Plasmabearbeitungsanlage vorteilhaft möglich, durch ein umlaufendes, metallisches, in die Reaktorseitenwand eingesetztes Distanzstück zwischen der Plasmaquelle und der Substratelektrode den Einfluß von hochfrequenten Magnetfeldern aus dem Bereich des erzeugten hochdichten Plasmas oder der ICP- Spule auf das Substrat oder beispielsweise einen dort angeordneten Siliziumwafer zusätzlich oder alternativ zu der genannten Aperturkonstruktion zu reduzieren. Das Distanzstück hat dazu vorzugsweise eine Höhe von ca. 10 cm - 30 cm und besteht vorzugsweise aus Aluminium oder einem anderen, gegenüber dem Plasmaprozeß beständigen Metall. Seine Verwendung vergrößert den Abstand zwischen der Plasmaquelle, d.h. dem Ort der Erzeugung des hochdichten Plasmas durch induktive Kopplung, und der Substratelektrode, die das Substrat trägt, und vermindert damit den Einfluß magnetischer und elektrischer Felder, die als Funktion des Abstands r mindestens wie 1/r abnehmen.

Da die Komponenten der erfindungsgemäßen Plasmabearbeitungsanlage keinen prinzipiellen Leistungsbeschränkungen unterliegen, können damit sehr vorteilhaft sehr hohe Quellenleistungen im Kilowattbereich nahezu verlustfrei gefahren werden. Durch das Fehlen energieabsorbierender Komponenten bleiben die benötigten Phasenbeziehungen zwischen den Spulenanschlüssen unabhängig von der zugeführten Leistung voll erhalten und es sind keine speziellen Maßnahmen zur Kühlung von Komponenten erforderlich. Damit ist eine exzellente Reproduzierbarkeit und Zuverlässigkeit der erfindungsgemäßen Plasmabearbeitungsanlage gegeben. Insbesondere schafft die Halbierung der Hochspannungsamplitude an den beiden Spulenenden sogar weiteren Freiraum für noch höhere Plasmaleistungen durch Hochskalieren der Leistungsparameter, so daß höchste Ätzraten in Silizium erreicht werden.

Gleichzeitig nehmen durch die erfindungsgemäße Plasmabearbeitungsanlage eine Vielzahl von Störeffekten wie das Wandsputtern, die Mikromaskierung durch abgesputterte Partikel, die Erzeugung hochenergetischer Ionen oder sehr heißer Elektronen im Plasma, eine unerwünschte Energiedissipation, eine kapazitive Einkopplung von Verschiebeströmen, eine Verzerrung des Plasmas durch elektrische Felder, eine Verschiebung der Plasmaverteilung, eine Erhöhung und Verzerrung des Plasmapotentials, Inhomogenitäten innerhalb des erzeugten Plasmas und Ausgleichsströme welche über Substrat und Substratelektrode nach Erde abfließen, deutlich ab.

### Zeichnung

Ausführungsbeispiele der Erfindung werden anhand der Zeichnung und in der nachfolgenden Beschreibung näher erläutert. Es zeigen Figur 1 eine Prinzipskizze einer Plasmabearbeitungsanlage im Schnitt, Figur 2 eine aus dem Stand der Technik bekannte asymmetrische Schaltung zur Speisung der ICP-Spule, Figur 3 eine erste symmetrische Schaltung, Figur 4 eine zweite symmetrische Schaltung und Figur 5 eine dritte symmetrische Schaltung zur Speisung der ICP-Spule.

### Ausführungsbeispiele

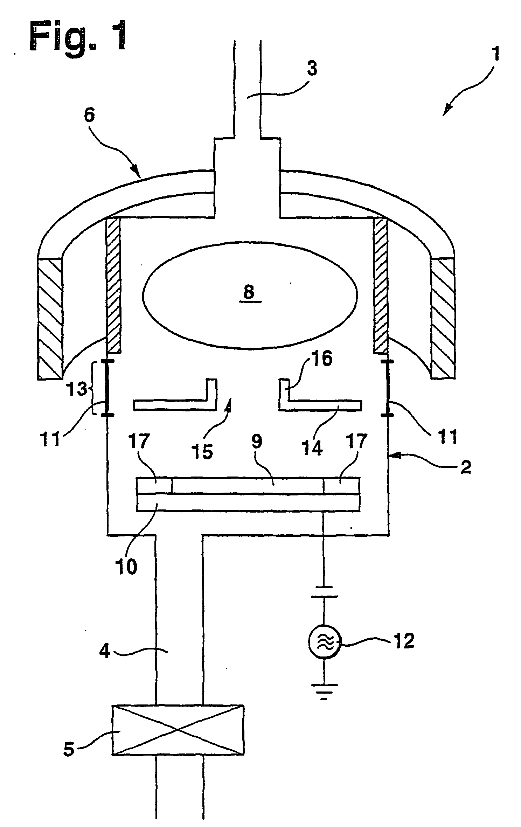

Die Figur 1 zeigt eine weitgehend aus der Anmeldung DE 197 34 278.7 bereits bekannte Plasmabearbeitungsanlage 1 in einer Prinzipskizze mit einem Reaktor 2, einem Zuführungsstutzen 3, beispielsweise zur Zuführung von Reaktiv- oder Ätzgasen, einem Absaugstutzen 4 mit einem Regelventil 5, über das in dem Reaktor 2 ein gewünschter Prozeßdruck eingestellt werden kann, einer ICP-Spule 6, die als Spule mit einer Windung ausgeführt ist und den Reaktor 2 im oberen Teil bereichsweise zumindest weitgehend umgibt. Der Reaktor 2 ist im Bereich der ICP-Spule 6 weitgehend aus einem keramischen Material in Form eines keramischen Kessels mit einem typischen Durchmesser von 40 cm und einer Höhe von 20 cm ausgeführt und weist eine Reaktorseitenwand 7 auf, in die unterhalb des keramischen Kessels ein metallisches Distanzstück 11 in Form eines umlaufenden Ringes eingesetzt ist. Das Distanzstück 11 hat eine Höhe von ca. 10 cm bis 30 cm und besteht insbesondere aus Aluminium. Innerhalb des Reaktors 2 wird im oberen Teil durch die ICP-Spule 6 in an sich bekannter Weise ein induktiv gekoppeltes, hochdichtes Plasma 8 erzeugt, indem in dem Reaktor 2 über die ICP-Spule 6 ein hochfrequentes elektromagnetisches Wechselfeld generiert wird, das auf ein Reaktivgas einwirkt und in dem Reaktor 2 als induktiv gekoppelte Plasmaquelle 18 das hochdichte Plasma 8 aus reaktiven Teilchen und Ionen erzeugt.

Im unteren Bereich des Reaktors 2 befindet sich ein Substrat 9, das beispielsweise ein durch Plasmaätzen zu bearbeitender Siliziumwafer mit einer entsprechenden Maskierung ist. Das Substrat 9 ist auf einer Substratelektrode 10 angeordnet und seitlich von an sich bekannten Absorbern 17 umgeben, die thermisch gut an die Substratelektrode ankoppeln und aus dem Plasma 8 auftreffende, überschüssige reaktive Teilchen verbrauchen. Als Absorbermaterial für Fluorteilchen als Ätzgasbestandteile eignet sich beispielsweise Silizium oder Graphit. Der Absorber 17 kann in einer alternativen Ausführungsform jedoch auch entfallen oder durch eine Quarz- oder Keramikabdeckung ersetzt sein. Die Substratelektrode 10 ist weiter in an sich bekannter Weise mit einer Hochfrequenzspannungsquelle 12 verbunden. Zur Homogenisierung der Plasmadichteverteilung und der Ionenstromdichte ist zwischen dem hochdichten Plasma 8 und dem Substrat 9 eine Apertur 13 eingesetzt, die eine Lochblende 14 aufweist und beispielsweise aus 15 mm dickem Aluminium gefertigt ist. Der Durchmesser der Öffnung 15 der Lochblende 14 ist größer als der Durchmesser eines zu bearbeitenden Wafers auf der Substratelektrode 10. Weiterhin befindet sich oberhalb der Lochblende 14 ein zylinderförmiger Schirm 16, der am Rand der Lochblende 14 befestigt ist. Der Schirm besteht aus Aluminium und hat eine Wandstärke von 10 mm und eine Höhe von 25 bis 49 mm.

Die Figur 2 zeigt schematisch eine aus dem Stand der Technik bekannte elektrische Schaltung zur Speisung der ICP-Spule 6 mit hochfrequenter Wechselspannung und einen Schnitt entlang der Schnittlinie II der Figur 1 durch die ICP-Spule 6 und das hochdichte Plasma 8 unter Weglassung der Reaktorseitenwand 7. Dabei wird über eine Hochfrequenzeinspeisung 23 eine hochfrequente Speisehochspannung über ein an sich bekanntes und handelsübliches Koaxialkabel, das eine Impedanz von 50 Ω hat, einem "heißen" Spulenende 20 der ICP-Spule 6 zugeführt, so daß dort eine hochfrequente Hochspannung V(t) von beispielsweise 3000 Volt gegen Erde anliegt. Ein zweites, "kaltes" Spulenende 21 ist mit einer Erdung 22 verbunden. Die ICP-Spule 6 definiert eine Spulenebene 41. Die Zu- bzw. Abführung der Hochfrequenzspannung zu dem "heißen" Spulenende 20 und die Erdung des "kalten" Spulenendes 21 erfolgt über elektrische Leiter 40. Zur Impedanzanpassung sind weiter zwei einstellbare Kondensatoren C₃ 25 und C₂ 24 vorgesehen. Ein weiterer Kondensator C₄ 26 stellt die Resonanzbedingung des zusammen mit der ICP-Spule 6 gebildeten Schwingkreises her.

Figur 3 zeigt als erstes Ausführungsbeispiel der Erfindung in Weiterentwicklung der bekannten Realisierung gemäß Figur 2 eine symmetrische Speisung der ICP-Spule 6 über ein erstes Spulenende 20' und ein zweites Spulenende 21', die nunmehr beide als "heiße" Spulenenden fungieren. Die Einspeisung einer hochfrequenten Wechselhochspannung erfolgt über die Hochfrequenzeinspeisung 23 zu einem ersten Speisespannungspunkt 32 und einem mit diesem in Verbidnug stehenden zweiten Speisespannungspunkt 31. Die Wechselhochspannung wird der Hochfrequenzeinspeisung 23 über ein übliches Koaxialkabel mit einer Impedanz von 50 Ω zugeführt.

Die Hochfrequenzeinspeisung 23 führt damit zunächst dem ersten Spulenende 20' über elektrische Leiter 40 eine hochfrequente Wechselhochspannung zu. Den ersten Speisespannungspunkt 32 und den zweiten Speisespannungspunkt 31 verbindet weiterhin eine λ/2-Verzögerungsleitung 30, die, abhängig von der gewählten Hochfrequenz, bei 13,56 MHz eine Länge von 7,2 Meter hat, und vorzugsweise ebenfalls aus üblichem Koaxialkabel mit einer Impedanz von 50 Ω besteht. Für diesen Fall ergeben sich minimale Verluste im Kabel und keine Abstrahlung durch stehende Wellen auf der λ/2-Verzögerungsleitung 30. Die Länge der λ/2-Verzögerungsleitung 30 bemißt sich dabei zu λ/2 * V, wobei V ein kabelabhängiger Verkürzungsfaktor ist, welcher für die meisten Koaxialkabel 0,65 beträgt, und λ die Wellenlänge der Hochfrequenzspannung bei Ausbreitung im Vakuum ist. Durch die λ/2-Verzögerungsleitung 30 liegt an den beiden Speisespannungspunkten 31, 32 somit jeweils eine hochfrequente Wechselhochspannung gleicher Frequenz und betragsmäßig zumindest nahezu gleicher Amplitude an, die gegeneinander um 180° phasenverschoben und damit gegenphasig sind. Insgesamt bildet die λ/2-Verzögerungsleitung 30 ein Spiegelbild der am ersten Speisespannungspunkt 32 anliegenden hochfrequenten Hochspannung und führt diese dem zweiten Speisespannungspunkt 31 zu. Gleichzeitig symmetrisiert sie die zugeführte Hochfrequenzleistung. Die über die Hochfrequenzeinspeisung 23 und die Speisespannungspunkte 31 und 32 den beiden Enden 20' und 21' der ICP-Spule 6 zugeführten hochfrequenten gegenphasigen Hochspannungen Û(t) und -Û(t) haben beispielsweise eine Amplitude von betragsmäßig jeweils 1500 Volt gegen Erde, die nur noch halb so groß ist, wie zuvor gemäß Figur 2 die am "heißen" Ende der ICP-Spule anliegende Spannung V(t).

Man erhält insgesamt eine erdsymmetrische Speisespannung an den beiden Kabelseelen, d.h. einen Spannungsverlauf +U(t) am Hochfrequenzspeisekabel im ersten Speisespannungspunkt 32 und einen Spannungsverlauf -U(t) am Ausgang der Verzögerungsleitung im zweiten Speisespannungspunkt 31, wobei die Spannungspunkte 31, 32 gegeneinander eine Impedanz von 200 Ω aufweisen (Impedanzvervierfachung gegenüber dem unsymmetrischen 50 Ω-Eingang). Dem ersten Spulenende 20' wird dadurch eine Spannung Û(t) und dem zweiten Spulenende eine Spannung -Û(t) zugeführt.

Zur Impedanzanpassung zwischen den Speisespannungspunkten 31, 32 und dem, über die ICP-Spule 6 und den Schwingkreiskondensator C₄ 26 erzeugten induktiven Plasma 8, sind weiterhin drei Kondensatoren C₂ 24, C₃ 25 und C₁ 27 vorgesehen, deren Kapazitäten im Fall von C₂ 24 und C₁ 27 abstimmbar sind, und die eine sogenannte "Matchbox" bilden. Dabei ist es für eine exakt symmetrische Speisung der ICP-Spule 6 vorteilhaft, wenn die Kapazität von Kondensator C₁ 27 gleich der von Kondensator C₃ 25 ist. Kleine Abweichungen von dieser Symmetrie können aber ohne schädlichen Prozeßeinfluß toleriert werden. Insbesondere ist es möglich, daß einer der beiden Kondensatoren, z.B. C₁ 27, ebenso wie auch der sogenannte "Load-Capacitor" C₂ als variabler Drehkondensator ausgeführt ist, der zur Impedanzanpassung verändert wird, während der andere Kondensator, z.B. C₃ 25, auf einem festen Wert gehalten wird, welcher näherungsweise die Kapazität des ersteren in einer angepaßten Position wiedergibt.

In der Tabelle 1 sind beispielhaft vorteilhafte Wertekombinationen der Kondensatoren C₂ 24, C₃ 25, C₄ 26 und C₁ 27 sowie die damit erzielte Symmetrie bzw. Asymmetrie, die durch das Verhältnis der Kapazitäten von C₁ zu C₃ gegeben ist, angegeben. Zur Bestimmung der benötigten optimalen Kapazitäten geht man günstigerweise iterativ vor und wählt zunächst beispielsweise einen plausiblen, festen Wert für die Kapazität des Kondensators C₃ 25. Daraufhin wird eine Impedanzanpassungsprozedur mit Hilfe der Kondensatoren C₁ 27 und C₂ 24 innerhalb der "Matchbox" durchgeführt, so daß eine optimale Anpassung der 200 Ω-Eingangsimpedanz zwischen den Speisespannungspunkten 32 und 31 an das erzeugte induktive Plasma 8 gegeben ist.

Aus dem Festwert der Kapazität von C₃ 25 und dem eingestellten Wert von der Kapazität von C₁ 27 ergibt sich eine aus der Serienschaltung beider Kondensatoren für die Impedanzanpassung maßgebliche resultierende Gesamtkapazität C'=C₁⁻¹ + C₃⁻¹)⁻¹. Wählt man nun eine neue, feste Kapazität des Festwertkondensators C₃ 25 mit einer Kapazität C₃' gemäß C₃' = (2 * C') = 2 * (C₁⁻¹ + C₃⁻ ¹)⁻¹, so wird die "Matchbox" mit diesem neuen Wert für die Kapazität des Kondensators C₃ 25 den variablen Kondensator C₁ 27 auf exakt denselben Wert einstellen, d.h. C₁ = C₃ = C', was auf dieselbe Gesamtkapazität der Serienschaltung und damit auf dieselbe Impedanztransformation führt wie zuvor, nun allerdings in einer symmetrischen Anordnung beider Kondensatoren C₁ und C₃ und damit der beiden Spulenspannungen an den beiden Spulenenden 21' und 20'. Mittels einer einzigen Iteration ist es also gelungen, den optimalen Festkapazitätswert des Kondensators C₃ 25 für einen symmetrischen angepaßten Betrieb der induktiven Quellenanordnung zu finden. Der Kondensator C₂ 24 und C₄ 26 sind für diese Betrachtungen ohne Belang, da sie die Symmetrie nicht beeinflussen.

**Tabelle 1:**

| | | |
|---|---|---|
| C₁ = | 323 pF | 390 pF |
| C₂ = | 245 pF | 245 pF |
| C₃ = | 450 pF | 375 pF |
| C₄ = | 150 pF | 150 pF |
| Asymmetrie: | 1.20 : 1 | 0.98 : 1 |

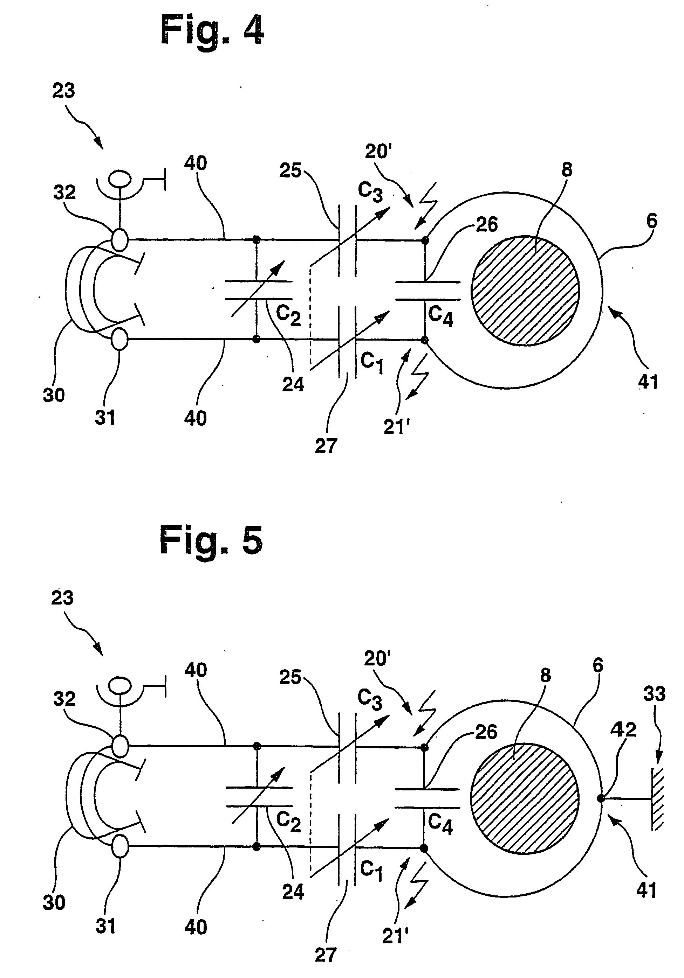

Die Figur 4 zeigt als weiteres Ausführungsbeispiel, bei ansonsten gleicher Ausführung wie mit Hilfe der Figuren 1 und 3 erläutert wurde, die Verwendung eines Tandemdrehkondensators für die beiden Kondensatoren C₁ 27 und C₃ 25, so daß beide Kapazitätswerte simultan variiert werden. Diese Tandemanordnung wird beispielsweise realisiert, indem die beiden Drehkondensatoren C₁ 27 und C₃ 25 mittels einer elektrisch isolierenden mechanischen Kupplung hintereinandergesetzt und damit simultan variiert werden, oder nebeneinander plaziert und mittels eines Ketten- oder Seiltriebs simultan bewegt werden.

In einer anderen Ausführungsform mit nebeneinanderliegenden Drehkondensatoren können auch elektrisch isolierende Zahnräder verwendet werden, um die beiden Drehkondensatorachsen mechanisch miteinander zu koppeln. Es ist weiter möglich, auch zwei autarke Drehkondensatoren C₁ 27 und C₃ 25 zu verwenden, die über Servomotoren synchron gesteuert werden. Bei Bedarf können zudem kleine, zusätzliche Trimmkondensatoren, die als Festwertkondensatoren den Drehkondensatoren C₁ 27 und C₃ 25 parallelgeschaltet sind, eingesetzt werden, um einen vollständigen Symmetrieabgleich zu erzielen. In jedem Fall wird somit erreicht, daß stets eine symmetrische Spulenspeisung in die ICP-Spule 6 erfolgt, so daß für eine große Prozeßvielfalt immer optimale Symmetrieverhältnisse in der ICP-Spule 6 und dem erzeugten hochdichten Plasma 8 vorliegen, so daß eine große Fülle von Strukturierungsprozessen mit ein und derselben Anlagenkonfiguration optimal abgedeckt werden kann.

In Tabelle 2 ist zusätzlich ein Satz optimaler Kapazitäten angegeben, die für das erläuterte Ausführungsbeispiel gemäß Figur 4, sowie auch für das folgende Ausführungsbeispiel gemäß Figur 5 geeignet sind.

**Tabelle 2:**

| | |
|---|---|
| C₁ = | 382 pF |
| C₂ = | 245 pF |
| C₃ = | C₁ |
| C₄ = | 150 pF |
| Asymmetrie: 1 : 1 | |

Die exakte symmetrische Spulenspeisung des mit Hilfe der Figur 4 erläuterten Ausführungsbeispiels hat den großen Vorzug, daß die Spulenmitte 42 jetzt jederzeit auf einer Spannung von 0 Volt liegt. Daher kann die Spulenmitte 42 nun explizit mit Hilfe einer Spulenerdung 33 geerdet werden, wie dies mit Hilfe von Figur 5 als weiteres Ausführungsbeispiel in Weiterführung von Figur 4 erläutert ist. Die explizite Erdung der Spulenmitte 42 löst das bei einer nicht fest mit dem Erdpotential verbundenen ICP-Spule 6 auftretende Problem, daß auf der ICP-Spule 6 sogenannte hochfrequente Gleichtaktspannungen auftreten. Diese hochfrequenten Gleichtaktspannungen, die den den Stromfluß in der ICP-Spule 6 treibenden hochfrequenten Gegentaktspannungen überlagert sind, sind an jedem Punkt der ICP-Spule 6 gleich und bewirken innerhalb des Spulenkreises selbst keinen Stromfluß.

Als Ursache für das Auftreten dieser Gleichtaktspannungen können geringe Phasenfehler zwischen den anliegenden hochfrequenten Hochspannungen an den beiden Spulenenden 20', 21', Rückwirkungen aus dem hochdichten Plasma 8 auf die ICP-Spule 6, sowie sonstige geringe Symmetriefehler verantwortlich sein. Eine Dämpfung der Gleichtaktspannung erfolgt nur durch eine kapazitive Kopplung in das hochdichte Plasma 8 und über induzierte Verschiebeströme durch die dielektrische Reaktorseitenwand 7 des Reaktors 8. Die ICP-Spule 6 wirkt somit teilweise wie eine Elektrode, die ein kapazitiv gekoppeltes Nebenplasma treibt - ähnlich einer bekannten Triodenanlage mit Dielektrikum zwischen Anode und Plasma. Die erwähnten induzierten Verschiebeströme im Plasma 8 sind relativ klein gegenüber den das induktive hochdichte Plasma 8 treibenden Spulenströmen. Entsprechend sind die dadurch zusätzlich in das Plasma 8 eingekoppelten Energiebeträge zunächst gering. Trotzdem können diese Gleichtaktspannungen die Plasmaeigenschaften, insbesondere bei sehr großen Hochfrequenzleistungen von mehr als 600 Watt an der ICP-Spule 6, signifikant verschlechtern. Durch das Anbringen der Spulenerdung 33 in der Spulenmitte 42 werden die genannten Gleichtaktspannungen an der ICP-Spule 6 wirksam unterdrückt, so daß sich beispielsweise die Profiltreue und Ätzratenhomogenität bei Plasmaätzprozessen insbesondere bei sehr hohen Hochfrequenzleistungen deutlich verbessern.

## Patentansprüche

1. Plasmabearbeitungsanlage zum Ätzen eines Substrates (9) mittels eines hochdichten Plasmas (8) in einem Reaktor (2) unter Verwendung einer ICP-Spule (6) mit einem ersten Spulenende (20, 20') und einem zweiten Spulenende (21, 21'), die über einen dem ersten Spulenende (20, 20') zugeordneten ersten Speisespannungspunkt (32) und einen dem zweiten Spulenende (21, 21') zugeordneten zweiten Speisespannungspunkt (31) mit einer Hochfrequenzeinspeisung (23) in Verbindung stehen, und an die über die Speisespannungspunkte (31, 32) mittels der Hochfrequenzeinspeisung (23) jeweils eine hochfrequente Wechselspannung gleicher Frequenz angelegt ist,
**dadurch gekennzeichnet, dass** der erste Speisespannungspunkt (32) und der zweite Speisespannungspunkt (31) durch eine λ/2-Verzögerungsleitung (30) derart miteinander verbunden sind, dass die an den beiden Spulenenden (20, 20', 21, 21') anliegenden hochfrequenten Wechselspannungen zumindest nahezu gegenphasig zueinander sind.

2. Plasmabearbeitungsanlage nach Anspruch 1, **dadurch gekennzeichnet, daß** die beiden an den beiden Spulenenden (20, 20', 21, 21') angelegten Wechselspannungen eine zumindest nahezu gleiche Amplitude aufweisen.

3. Plasmabearbeitungsanlage nach Anspruch 1, **dadurch gekennzeichnet, daß** die ICP-Spule (6) nur eine Windung hat.

4. Plasmabearbeitungsanlage nach Anspruch 1, **dadurch gekennzeichnet, daß** die ICP-Spule (6) den Reaktor (2) bereichsweise zumindest weitgehend umgibt.

5. Plasmabearbeitungsanlage nach Anspruch 1, **dadurch gekennzeichnet, daß** in dem Reaktor (2) zwischen einer Plasmaquelle (18) als Ort der Erzeugung des hochdichten Plasmas (8) und dem Substrat (9) eine Apertur (13) vorgesehen ist.

6. Plasmabearbeitungsanlage nach Anspruch 1, **dadurch gekennzeichnet, daß** das Substrat (9) auf einer Substratelektrode (10) angeordnet ist, die mit einer Hochfrequenzspannungsquelle (12) verbunden ist

7. Plasmabearbeitungsanlage nach Anspruch 1, **dadurch gekennzeichnet, daß** das Anlegen der hochfrequenten Wechselspannungen an das erste Spulenende (20, 20') und das zweite Spulenende (21, 21') über elektrische Leiter (40) erfolgt, die parallel zu einer von der ICP-Spule (6) gebildeten Spulenebene (41) geführt sind.

8. Plasmabearbeitungsanlage nach Anspruch 1, **dadurch gekennzeichnet, daß** in einer Umgebung der ICP-Spule (6) und/oder des Reaktors (2) auftretende Ströme derart geführt sind, daß sie parallel zu einer von der ICP-Spule (6) gebildeten Spulenebene (41) verlaufen.

9. Plasmabearbeitungsanlage nach Anspruch 1, **dadurch gekennzeichnet, daß** zwischen den beiden Speisespannungspunkten (30, 31) und den beiden damit in Verbindung stehenden Spulenenden (20', 21') eine elektrische Schaltung zur Impedanzanpassung vorgesehen ist.

10. Plasmabearbeitungsanlage nach Anspruch 9, **dadurch gekennzeichnet, daß** die elektrische Schaltung ein kapazitives Netzwerk mit Kondensatoren (24, 25, 26, 27) ist.

11. Plasmabeschichtungsanlage nach Anspruch 10, **dadurch gekennzeichnet, daß** das kapazitive Netzwerk zumindest weitgehend symmetrisch und insbesondere abstimmbar ist.

12. Plasmabearbeitungsanlage nach Anspruch 1, **dadurch gekennzeichnet, daß** die Spulenmitte (42) der ICP-Spule (6) geerdet ist.

13. Plasmabearbeitungsanlage nach Anspruch 1 oder 4, **dadurch gekennzeichnet, daß** die ICP-Spule (6) den Reaktor (2), der insbesondere als kreisförmiger keramischer Kessel ausgeführt ist, derart umgibt, daß die Spulenenden (20, 20', 21, 21') einen maximalen Abstand zu dem Reaktor (2) aufweisen.

14. Plasmabearbeitungsanlage nach Anspruch 1, **dadurch gekennzeichnet, daß** das Substrat (9) und/oder die ICP-Spule (6) derart angeordnet ist, daß der Abstand zwischen dem Substrat (9) und ICP-Spule (6) senkrecht zur Spulenebene (41) maximal ist.

15. Plasmabearbeitungsanlage nach Anspruch 1, **dadurch gekennzeichnet, daß** zwischen dem in dem Reaktor (2) erzeugten hochdichten Plasma (8) als Plasmaquelle (18) und dem Substrat (9) in die Reaktorseitenwand (7) ein umlaufendes metallisches Distanzstück (11) eingesetzt ist.

## Claims

1. Plasma processing system for etching a substrate (9) by means of a high-density plasma (8) in a reactor (2) with the use of an ICP coil (6) having a first coil end (20, 20') and a second coil end (21, 21'), which are connected to a radiofrequency feed (23) via a first feed voltage point (32) assigned to the first coil end (20, 20') and a second feed voltage point (31) assigned to the second coil end (21, 21'), and to which a radiofrequency AC voltage of equal frequency is in each case applied via the feed voltage points (31, 32) by means of the radiofrequency feed (23), **characterised in that** the first feed voltage point (32) and the second feed voltage point (31) are connected to one another, through a λ/2 delay line (30), in such a way that the radiofrequency AC voltages applied to the two coil ends (20, 20', 21, 21') are at least approximately in antiphase with one another.

2. Plasma processing system according to Claim 1, **characterised in that** the two radiofrequency AC voltages applied to the two coil ends (20, 20', 21, 21') have an at least approximately equal amplitude.

3. Plasma processing system according to Claim 1, **characterised in that** the ICP coil (6) has only one turn.

4. Plasma processing system according to Claim 1, **characterised in that** the ICP coil (6) at least substantially surrounds parts of the reactor (2).

5. Plasma processing system according to Claim 1, **characterised in that** an aperture (13) is provided in the reactor (2), between a plasma source (18), as the site where the high-density plasma (8) is generated, and the substrate (9).

6. Plasma processing system according to Claim 1, **characterised in that** the substrate (9) is arranged on a substrate electrode (10), which is connected to a radiofrequency voltage source (12).

7. Plasma processing system according to Claim 1, **characterised in that** the radiofrequency AC voltages are applied to the first coil end (20, 20') and the second coil end (21, 21') via electrical conductors (40), which are routed parallel to a coil plane (41) formed by the ICP coil (6).

8. Plasma processing system according to Claim 1, **characterised in that** currents occurring in proximity to the ICP coil (6) and/or the reactor (2) are routed in such a way that they run parallel to a coil plane (41) formed by the ICP coil (6).

9. Plasma processing system according to Claim 1, **characterised in that** an electrical circuit for impedance matching is provided between the two feed voltage points (30, 31) and the two coil ends (20', 21') connected thereto.

10. Plasma processing system according to Claim 9, **characterised in that** the electrical circuit is a capacitive network having capacitors (24, 25, 26, 27).

11. Plasma processing system according to Claim 10, **characterised in that** the capacitive network is at least substantially symmetrical and, in particular, tunable.

12. Plasma processing system according to Claim 1, **characterised in that** the coil centre (42) of the ICP coil (6) is earthed.

13. Plasma processing system according to Claim 1 or 4, **characterised in that** the ICP coil (6) surrounds the reactor (2), which, in particular, is designed as a circular ceramic vessel, in such a way that the coil ends (20, 20', 21, 21') are at a maximum distance from the reactor (2).

14. Plasma processing system according to Claim 1, **characterised in that** the substrate (9) and/or the ICP coil (6) are arranged in such a way that the distance between the substrate (9) and the ICP coil (6) at right angles to the coil plane (41) is a maximum.

15. Plasma processing system according to Claim 1, **characterised in that** a circumferential metallic spacer (11) is fitted into the reactor side wall (7), between the high-density plasma (8), as the plasma source (18), generated in the reactor (2) and the substrate (9).

## Revendications

1. Installation d'usinage au plasma pour graver un substrat (9) à l'aide d'un plasma (8) très dense dans un réacteur (2) en utilisant une bobine ICP (6) avec une première extrémité de bobine (20, 20') et une seconde extrémité de bobine (21, 21'), reliées par un premier point de tension d'alimentation (32) associé à la première extrémité de bobine (20, 20') et un second point d'alimentation de tension (31) associé à la seconde extrémité de bobine (21, 21') pour recevoir une tension à haute fréquence (23), et dont les points d'alimentation en tension (31, 32) reçoivent par l'alimentation à haute fréquence (23) chaque fois une tension alternative à haute fréquence de même fréquence,
**caractérisée en ce que**
le premier point d'alimentation en tension (32) et le second point d'alimentation en tension (31) sont reliés l'un à l'autre par une ligne de retard λ/2 (30), de façon que les tensions alternatives à haute fréquence appliquées aux deux extrémités de bobines (20, 20' ; 21, 21') soient au moins sensiblement en opposition de phase.

2. Installation d'usinage au plasma selon la revendication 1,
**caractérisée en ce que**
les deux tensions alternatives appliquées aux deux extrémités de bobines (20, 20' ; 21, 21') ont au moins sensiblement la même amplitude.

3. Installation d'usinage au plasma selon la revendication 1,
**caractérisée en ce que**
la bobine ICP (6) ne comporte qu'une spire.

4. Installation d'usinage au plasma selon la revendication 1,
**caractérisée en ce que**
la bobine ICP (6) entoure au moins en grande partie, par zone, le réacteur (2).

5. Installation d'usinage au plasma selon la revendication 1,
**caractérisée en ce que**
dans le réacteur (2), entre une source de plasma (18), comme emplacement pour générer le plasma très dense (8) et le substrat (9), il est prévu une ouverture (13).

6. Installation d'usinage au plasma selon la revendication 1,
**caractérisée en ce que**
le substrat (9) est installé sur une électrode (10) reliée à une source de tension à haute fréquence (12).

7. Installation d'usinage au plasma selon la revendication 1,
**caractérisée en ce que**
l'application des tensions alternatives à haute fréquence à la première extrémité de bobine (20, 20') et à la seconde extrémité de bobine (21, 21') se fait par des conducteurs électriques (40) parallèles à un plan de bobine (41) formé par la bobine ICP (6).

8. Installation d'usinage au plasma selon la revendication 1,
**caractérisée en ce que**
dans l'environnement de la bobine ICP (6) et/ou du réacteur (2), les courants produits sont guidés de façon à être parallèles à un plan de bobine (41) formé par la bobine ICP (6).

9. Installation d'usinage au plasma selon la revendication 1,
**caractérisée en ce qu'**
entre les deux points d'alimentation de tension (30, 31) et les deux extrémités de bobines (20, 21') en liaison avec eux on a un circuit électrique d'adaptation d'impédance.

10. Installation d'usinage au plasma selon la revendication 9,
**caractérisée en ce que**
le circuit électrique a un réseau capacitif formé de condensateurs (24, 25, 26, 27).

11. Installation d'usinage au plasma selon la revendication 10,
**caractérisée en ce que**
le réseau capacitif est au moins très largement symétrique et notamment équilibré.

12. Installation d'usinage au plasma selon la revendication 1,
**caractérisée en ce que**
le milieu (42) de la bobine ICP (6) est relié à la masse.

13. Installation d'usinage au plasma selon l'une quelconque des revendications 1 ou 4,
**caractérisée en ce que**
la bobine ICP (6) entoure la cuve en céramique notamment de forme circulaire de sorte que les extrémités de bobines (20, 20', 21, 21') aient une distance maximale par rapport au réacteur (2).

14. Installation d'usinage au plasma selon la revendication 1,
**caractérisée en ce que**
le substrat (9) et/ou la bobine ICP (6) sont installés de façon que perpendiculairement au plan de bobine (41), la distance entre le substrat (9) et la bobine ICP (6) soit maximale.

15. Installation d'usinage au plasma selon la revendication 1,
**caractérisée en ce qu'**
une pièce d'écartement métallique (11), périphérique, est placée entre le plasma très dense (8) généré dans le réacteur (2) comme source de plasma (18) et le substrat (9) dans la paroi latérale (7) du réacteur.
